# EUROPEAN PATENT APPLICATION

(11) **EP 4 525 035 A1**
(43) Date of publication of application: **19.03.2025**
(21) Application number: 24197250.4
(22) Date of filing: 29.08.2024
(51) Int. Cl.: H01L 23/38, H01L 23/34

(54) **THERMAL APPARATUS FOR AN INTEGRATED CIRCUIT AND METHODS OF OPERATION**

(30) Priority: 12.09.2023 IN 202341061226
(71) Applicant: NXP USA, Inc., Austin TX 78735 (US)
(72) Inventor: Sharma, Chetan, 5656 AG Eindhoven (NL); Upreti, Dinesh, 5656 AG Eindhoven (NL)
(74) Representative: Miles, John Richard

(57) **Abstract**

Apparatus and method for improving reliability of an integrated circuit. The apparatus comprises an integrated circuit and a heatsink which is in contact with package of the integrated circuit. A Peltier element comprises a first surface and a second surface and is positioned in a cavity of the heatsink. Based on a first indication from a sensor, a controller applies a first polarity to a first terminal and second terminal of the Peltier element to reduce a temperature of the second surface to cool the integrated circuit and based on a second indication from the sensor, the controller applies a second polarity to the first terminal and second terminal of the Peltier element to increase the temperature of the second surface to heat the integrated circuit.

## Description

### FIELD OF USE

This disclosure generally relates to increasing reliability of an integrated circuit, and specifically a thermal apparatus and methods of operation to provide heating and cooling of the integrated circuit based on a Peltier effect to maintain a temperature of the integrated circuit in a temperature range and maintain reliability of the integrated circuit.

### BACKGROUND

An integrated circuit is designed to ideally operate at a preferred temperature, but the integrated circuit is typically subject to temperatures other than the preferred temperature during operation. Operating the integrated circuit at temperatures other than the preferred temperature reduces reliability of the integrated circuit. To improve the reliability, the integrated circuit is heated or cooled so that the temperature of the integrated circuit operates at the preferred temperature.

### BRIEF DESCRIPTION OF THE DRAWINGS

FIG. 1 illustrates an example apparatus for controlling a temperature of an integrated circuit in accordance with an embodiment.
FIG. 2 illustrates an example preferred temperature range which the integrated circuit is to operate in accordance with an embodiment.
FIG. 3 illustrates example circuitry of the apparatus for controlling the temperature of the integrated circuit in accordance with an embodiment.
FIG. 4 illustrates an example operation of the apparatus when the temperature of the integrated circuit is to be reduced in accordance with an embodiment.
FIG. 5 illustrates an example operation of the apparatus when the temperature of the integrated circuit is to be increased in accordance with an embodiment.
FIG. 6 illustrates an example operation of the apparatus when the temperature of the integrated circuit is to be maintained in accordance with an embodiment.
FIG. 7 is an example flow chart of example functions associated with operating the apparatus in accordance with an embodiment.

The drawings are for the purpose of illustrating example embodiments, but it is understood that the embodiments are not limited to the arrangements and instrumentality shown in the drawings.

### DETAILED DESCRIPTION

The detailed description of the appended drawings is intended as a description of the various embodiments of the present disclosure, and is not intended to represent the only form in which the present disclosure may be practiced. It is to be understood that the same or equivalent functions may be accomplished by different embodiments that are intended to be encompassed within the spirit and scope of the present disclosure.

A heat sink is used to reduce overheating of the integrated circuit when the integrated circuit is subject to temperatures exceeding a preferred temperature and a separate resistive element is used to increase temperature of the integrated circuit when the integrated circuit is subject to temperatures below a preferred temperature. The heat sink or resistive element are physically separate apparatus to decrease temperature of the integrated circuit or increase temperature of the integrated circuit with respect to the preferred temperature to increase reliability of the integrated circuit.

Embodiments disclosed herein are directed to an apparatus and a method for controlling a temperature of an integrated circuit which is below or above a preferred temperature range to be within the preferred temperature range using a Peltier element. The apparatus includes a heat sink and a Peltier element located in a cavity of the heat sink with one surface of the Peltier element located closest to a bottom surface of the heat sink and another surface of the Peltier element located closest to a top surface of the heat sink. The bottom surface of the heat sink with the Peltier element is further arranged to contact packaging of the integrated circuit. The Peltier element has two terminals and polarity between the two terminals is controlled to determine whether a temperature of the integrated circuit referred to as a junction temperature is increased or decreased. In one example, the Peltier element controls a direction of heat flow to increase the junction temperature and in another example, the Peltier element controls a direction of heat flow to decrease the junction temperature. The junction temperature is indicative of the temperature of the integrated circuit. The apparatus or integrated circuit further has a sensor and the apparatus has a controller to measure and control the junction temperature based on the sensor. The controller determines whether the junction temperature is above a high end of the preferred temperature range or below a low end of the preferred temperature range. If the junction temperature is above the preferred temperature range, then the controller causes a first polarity to be applied to terminals of the Peltier element to cool the integrated circuit and reduce the temperature of the integrated circuit. Alternatively, if the junction temperature is below the preferred range, then the monitoring logic causes a second polarity opposite to the first polarity to be applied to terminals of the Peltier element to heat the integrated circuit and increase the temperature of the integrated circuit. Still alternatively, if the junction temperature is already within the preferred temperature range, then the controller does not apply a polarity to the terminals of the Peltier element so that the integrated circuit is not cooled or heated by the Peltier element. The integrated circuit is able to remain in the preferred temperature range while the apparatus provides a single thermal solution in the form of the Peltier element to heat or cool the integrated circuits exposed to varied temperatures to maintain reliability of the integrated circuit with less complexity compared implementing separate apparatus to heat or cool the integrated circuit. Well known instructions, protocols, structures, and techniques have not been shown in detail in order not to obfuscate the description.

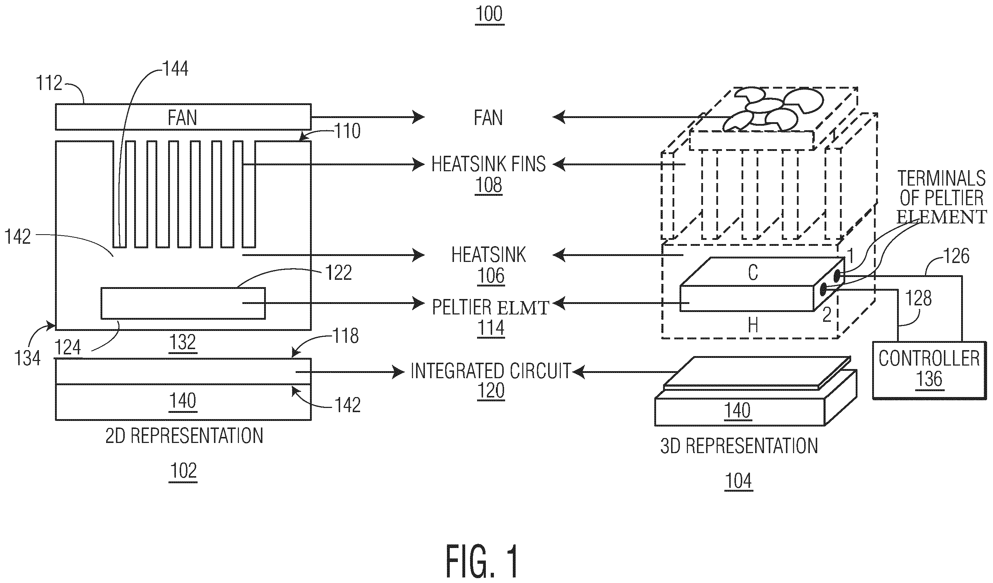

FIG. 1 illustrates an example apparatus 100 for controlling temperature of an integrated circuit in accordance with an embodiment. The apparatus 100 is shown as a two dimensional representation 102 and three dimensional representation 104. The apparatus 100 includes a heat sink 106, a plurality of heatsink fins 108, a fan 112, and a Peltier element 114. The heatsink 106 which may be constructed of a metal such as aluminum or an alloy may have a top surface 142 and a bottom surface 134 and the Peltier element 114 may have a top surface 122 and a bottom surface 124. In an example, the Peltier element 114 may be positioned in a cavity of the heatsink 106 and the top surface 122 of the Peltier element 114 may be located closest to the top surface 142 of the heat sink 106 and the bottom surface 124 of the Peltier element may be located closest to the bottom surface 134 of the heatsink 106. Further, the heatsink fins 108 which may be constructed of a metal such as aluminum or an alloy may have a bottom surface 144 and a top surface 110. The bottom surface 144 may be in affixed or integrated with the top surface 142 and the top surface 110 may be in contact with the fan 112 and affixed or integrated with the fan 112. In an example, the Peltier element 114 may be positioned in a cavity of the heat sink 106 and surfaces of the Peltier element 114 may be contact with the heat sink 106. In an example, the bottom surface 134 of the heat sink may be affixed and in contact with packaging 132 of an integrated circuit 120. Two surfaces may be defined to be in contact with each other as described herein either directly where no thermally conductive material may separate the two surfaces and in other examples the two surfaces may be in contact with each other indirectly where a thermally conductive material may separate the two surfaces. Further, the integrated circuit 120 may be mounted on a circuit board 140 such as a printed circuit board. A controller 136 may control the temperature of the integrated circuit 120. The controller 136 may have circuity for performing the control. In some examples, certain circuitry of the controller 136 may be implemented in the integrated circuit 120 rather than being physically separated from the integrated circuit 120.

In an example, the Peltier element 114 may be comprised of a semiconductor fabricated from N-type and P-type Bismuth Telluride materials sandwiched between ceramic substrates as an example. The ceramic substrates may be surfaces 122, 124 and the surfaces 122, 124 may be referred to as ceramic substrates 122, 124 interchangeably. Two terminals 126, 128 are coupled to the ceramic substrates respectively and the controller 136 applies a voltage to the two terminals 126, 128. The Peltier element 114 operates such that when current flows from the first terminal 126 to the second terminal 128 one of the ceramic substrates 122, 124 is heated and another is cooled while when current flows from the second terminal 128 to the first terminal 126 opposite ceramic substrates 122, 124 to what was heated and cooled are now heated and cooled.

The integrated circuit 120 may operate in an environment with an ambient temperature which affects a temperature of the integrated circuit 120 typically referred as junction temperature Tj of the integrated circuit. Further, the junction temperature of the integrated circuit 120 may be affected by heat generated during operation of the integrated circuit 120. The integrated circuit 120 may be designed to operate in a preferred temperature range which is defined by a high end temperature and a low end temperature to maximize intrinsic reliability and resulting lifespan of the integrated circuit 120. The apparatus 100 may operate to maintain the junction temperature of the integrated circuit 120 in this temperature range when ambient temperature may vary and while the integrated circuit 120 is operational. The controller 136 may output a voltage to the terminals 126, 128 to produce a first polarity across the terminals to cool the ceramic substrate 124 and heat the ceramic substrate 122 to reduce the junction temperature of the integrated circuit 120 when the junction temperature exceeds a high end of the preferred temperature range. Alternatively, the controller 136 may output a voltage to the terminals 126, 128 to produce a second polarity across the terminals to heat the ceramic substrate 124 and cool the ceramic substrate 122 to increase the junction temperature of the integrated circuit 120 when the junction temperature is below a low end of the preferred temperature range. The first polarity may be a potential difference with a first value and the second polarity may be a potential difference with a second value and in some examples one value may be positive and one value may be negative. The integrated circuit 120 is able to remain in the preferred temperature range and maintain high intrinsic reliability of the integrated circuit while the Peltier element 114 provides a single thermal solution for maintaining the junction temperature of the integrated circuit 120.

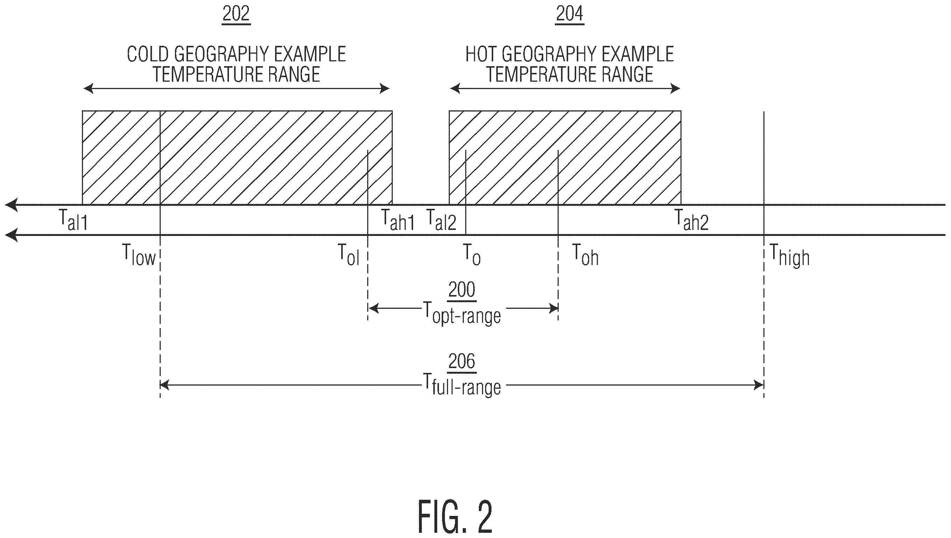

FIG. 2 illustrates an example preferred temperature range 200 of the integrated circuit 120 in accordance with an embodiment. The integrated circuit 120 may be designed to operate in the preferred temperature range 200 to achieve a certain reliability. The preferred temperature range 200 shown as Topt-range is defined by a circuit optimal low range Tol, circuit optimal high range Toh, Within the Topt-range To may be an optimal temperature of the integrated circuit 120 within the Topt-range. Further, the integrated circuit 120 may be in an environment with an ambient temperature which may span different ranges. In a cold geography 202, the temperature of the integrated circuit 120 may range from a cold ambient temperature low end Tal1 to a high ambient temperature high end Tah1 while in a hot geography 204, the temperature of the integrated circuit 120 may range from a high ambient temperature low end Tal2 to a high ambient temperature high end Tah2. The temperature between the Tal1 and Tah2 may define a full operating range 206 of the ambient temperature in which the integrated circuit 120 may operate but reliability of the integrated circuit 120 may vary depending on the specific junction temperature. To achieve the highest reliability, the junction temperature of the integrated circuit 120 should be in the Topt-range and ideally the optimal temperature To. In an example, the Peltier element 114 associated with the apparatus 100 provides a single thermal solution to maintain a junction temperature for the integrated circuit 120 for applications such as automotive chips in field vehicles across hot and cold geographies. The apparatus 100 ensures uniform logic of sensing, decision making, and applying temperature control to keep the integrated circuit 120 working within its specified optimal temperature range and may be replicated across multiple chips based on each chip's optimal range specifications.

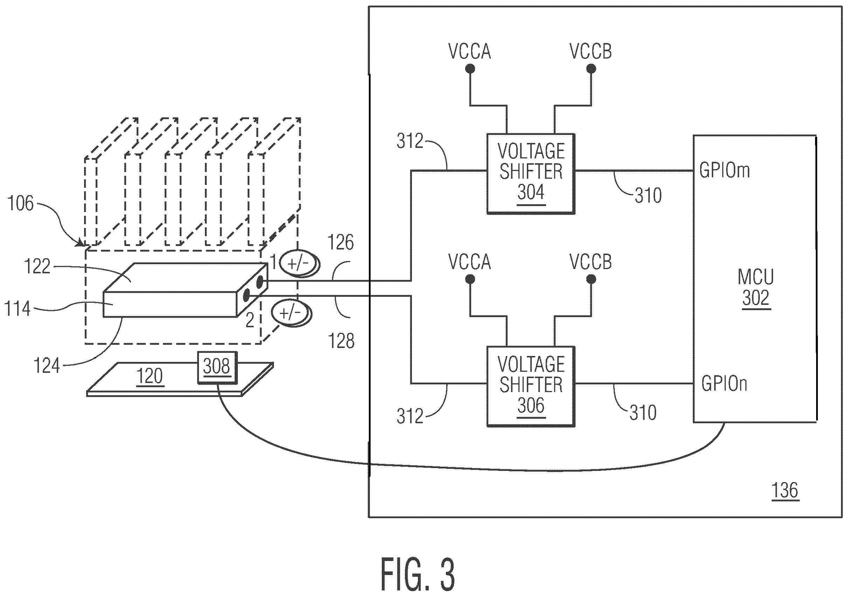

FIG. 3 illustrates an example circuitry of the controller 136 for operating the apparatus 100 in accordance with an embodiment. The controller 136 may have processing circuity (also referred to as microcontroller unit or MCU) 302 and a voltage shifter 304, 306. A sensor 308 may be a circuit located on or integral with the integrated circuit 120 and which senses the junction temperature of the integrated circuit 120 such as a temperature sensor or voltage sensor that outputs a voltage indicative of the junction temperature. In an example, at least a portion of the MCU 302 may be implemented in the integrated circuit 120. An indication of this junction temperature is provided to the processing circuity 302. The voltage shifters may cause a respective voltage to be applied to the terminals 126, 128 of the Peltier element 114 to produce a polarity across the terminals 126, 128. The voltage may be defined by characteristics or a specification of the Peltier element 114. The voltage shifters may have a respective input 310 and output 312. The volage that is output by a voltage shifter at the output 312 may depend on a signal applied to the input 310 of the voltage shifter. If a first signal is applied to the input of voltage shifter, then the voltage shifter may output a first voltage while if a second signal is applied to the voltage shifter, then the voltage shifter may output a second voltage. The first signal and second signal may be different signals such as logic 0 or logic 1 and the first voltage and second voltage may be different voltages. Based on the junction temperature indicated by the sensor 308, the controller 136 may output the first signal to the voltage shifter 304 and the second signal to the voltage shifter 306 or vice versa. If the controller 136 outputs the first signal to the voltage shifter 304 and the second signal to the voltage shifter 306, a first and second voltage may be applied to the terminals 126, 128 respectively to produce a first polarity across the terminals and cause a heating of the ceramic substrate 122 and a cooling of the ceramic substate 124. If the controller 136 outputs the first signal to the voltage shifter 306 and the second signal to the voltage shifter 304, the first and second voltage may be applied to the terminals 126, 128 respectively to produce a second polarity across the terminals and cause a heating of the ceramic substrate 124 and a cooling of the ceramic substate 122 where the first and second polarities are opposite such as positive and negative polarities. The controller 136 may apply the voltages to adjust the junction temperature of the integrated circuit 120 to be within the preferred temperature range.

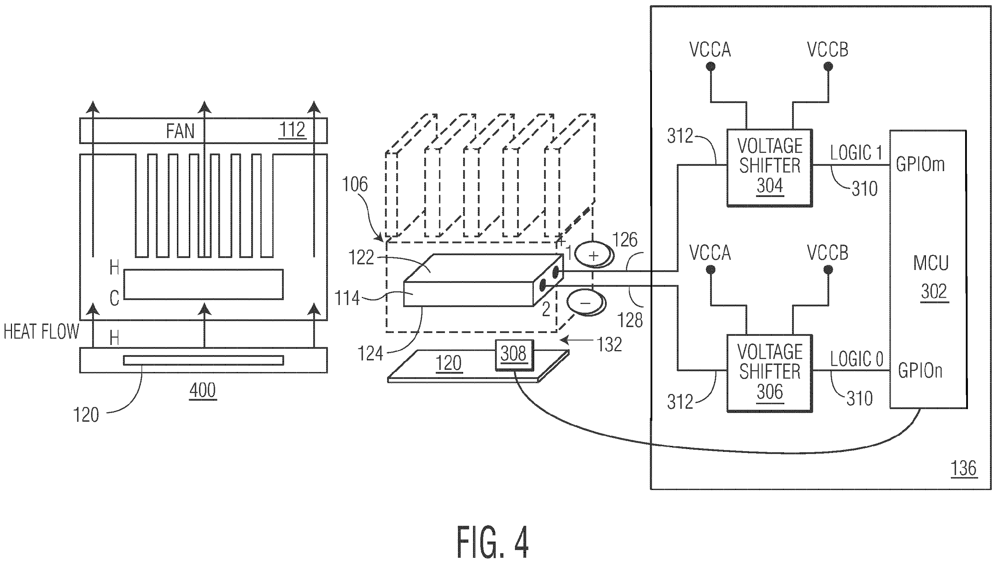

FIG. 4 illustrates an example operation of the apparatus 100 when a junction temperature of the integrated circuit is to be reduced in accordance with an embodiment. The integrated circuit 120 may be located in a hot geography in this example or generating heat during operation. In an example, the controller 136 may receive an indication of the junction temperature from the sensor 308 and determine that a junction temperature Tj is greater than Toh which is a high range of the optimal temperature range Topt-range of the integrated circuit 120. The high junction temperature is shown by "H" above the integrated circuit 120. The voltage shifter may output one of two voltages VCCA and Ground (GND) depending on a logic level received from the controller 136 at the input of the voltage shifter. VCCB is a reference voltage provided to the voltage shifter, and this reference volage may correspond to the controller's GPIO logic 1. In an example, the VCCA may be 5 volts and the VCCB may be 1.8 volts and the logic level 1 and 0 corresponds to 1.8 volts and GND respectively such that the voltage shifter shifts from a 1.8 volt domain to the 5 volt domain. In an example, the logic levels output by the controller 136 may cause a certain polarity to be applied across the terminals 126, 128 based on the two voltages. In an example, the processing circuity 302 may configure voltage shifter 304 with a logic level such as logic high "1", while the other voltage shifter 306 is configured to another logic level such as logic low "0" so that voltage shifter 304 outputs VCCA to terminal 126 and voltage shifter 306 outputs GND to terminal 128 and a polarity between the terminals of the Peltier element is created such that the ceramic substrate 124 starts cooling ("C") and the ceramic substrate 122 starts heating ("H"). Cooling of the ceramic substrate 124 creates a higher temperature difference between the integrated circuit 120 and the heat sink 106, leading to an increased heat dissipation from the integrated circuit 120 to the heat sink 106 as heat moves from hot to cold, decreasing the junction temperature. The heat dissipation continues as long as a temperature difference is maintained. The controller 136 continues to apply the polarity between the terminals of the Peltier element 114 until the sensor 308 indicates to the controller 136 that the junction temperature reaches within the optimal temperature range Topt-range or optimal temperature To. The heat flow based on conduction and radiation is shown by a two dimensional diagram 400 marked with arrows. The hotter surface is marked with an `H', and the relatively cooler surface are marked with a 'C' to help understand the direction of heat flow. Additionally, the fan 112 is switched on to maximize heat radiation by the heatsink fins 108.

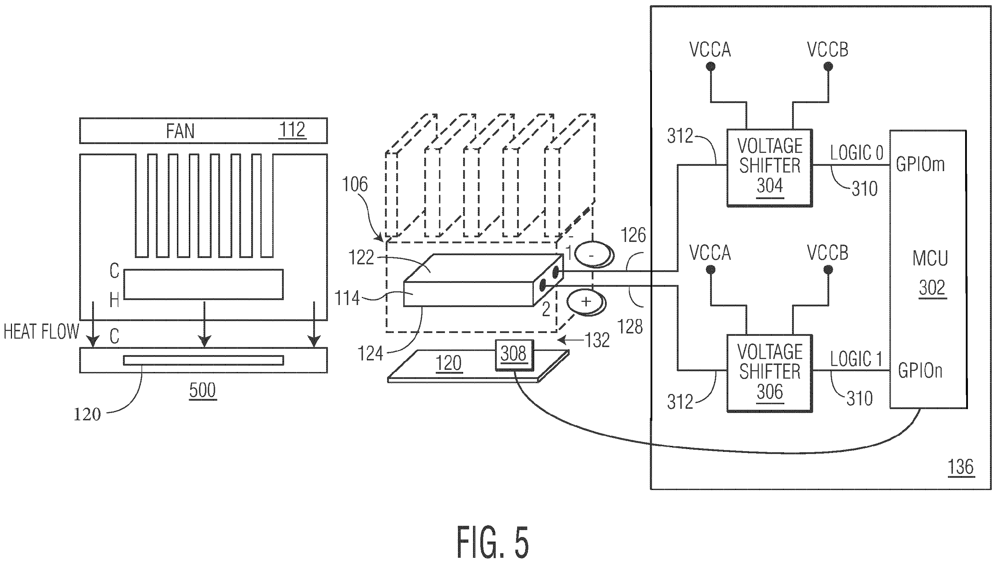

FIG. 5 illustrates an example operation of the apparatus 100 when a junction temperature of the integrated circuit is to be increased in accordance with an embodiment. The integrated circuit 120 may be located in a cold geography in this example or not generating much heat during operation. In an example, the controller 136 may receive an indication of the junction temperature from the sensor 308 and determine that a junction temperature Tj is less than Tol which is a low range of the optimal temperature range To of the integrated circuit 120. The voltage shifter may output one of two voltages VCCA and GND depending on a logic level received from the controller 136 at the input of the voltage shifter. The logic levels output may cause a certain polarity to be applied across the terminals 126, 128 based on the two voltages. In an example, the controller 136 may configure voltage shifter 304 with a logic level such as logic low "0", while the other voltage shifter 306 is configured to another logic level such as logic high "1" so that the voltage shifter 306 outputs VCCA to terminal 128 and the voltage shifter 304 outputs GND to terminal 126 and a polarity between the terminals of the Peltier element is created such that the ceramic substrate 124 starts heating and the ceramic substrate 122 starts cooling. In an example, a polarity applied across the terminals 126, 128 associated with when the ceramic substrate 124 starts heating may be opposite to a polarity applied across the terminals 126, 128 associated with when the ceramic substrate 124 starts cooling. For instance, the polarity applied across the terminals 126, 128 in FIG. 5 to heat the ceramic substrate 124 be positive while the polarity applied across the terminals 126, 128 in FIG. 4 to cool the ceramic substrate 124 may be negative, or vice versa. Heating of the ceramic substrate 124 creates a higher temperature difference between the integrated circuit 120 and the heat sink 106, leading to an increased heat dissipation rate toward the integrated circuit 120, increasing the junction temperature. The heat dissipation continues as long as a temperature difference is maintained. The controller 136 continues to apply the polarity between the terminals of the Peltier element 114 until the sensor 308 indicates to the controller 136 that the junction temperature reaches within the optimal temperature range or the optimal temperature. The heat flow based on conduction and radiation is shown by the two dimensional diagram 500 marked with arrows. The hotter surface is marked with an `H', and the relatively cooler surface are marked with a 'C' to help understand the direction of heat flow. Additionally, the fan 112 is switched off to minimize heat radiation.

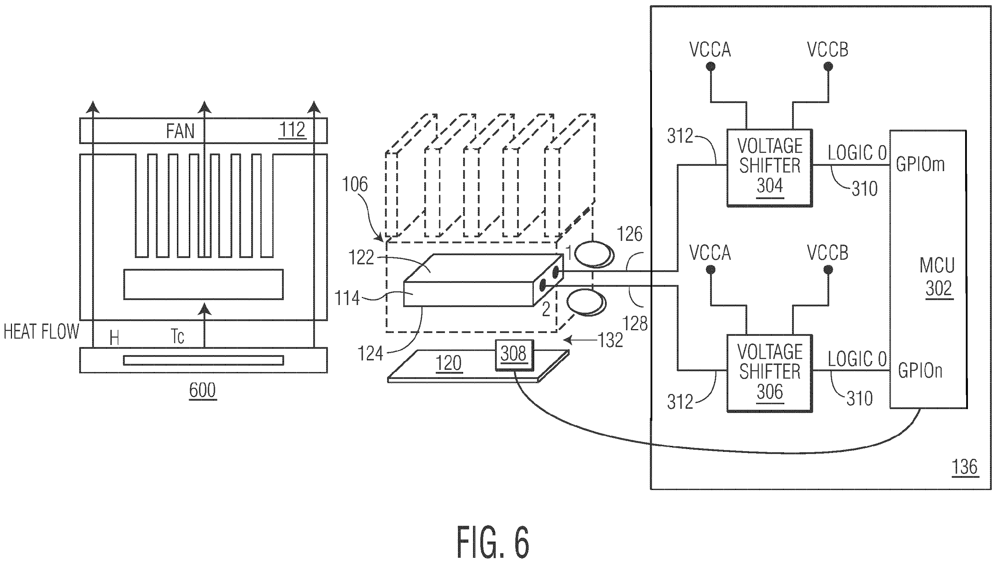

FIG. 6 illustrates an example operation of the apparatus 100 when a junction temperature of the integrated circuit is to be maintained in accordance with an embodiment. The controller 136 may maintain the junction temperature when Tj =To in an example. In this scenario, the controller 136 may receive an indication of the junction temperature from the sensor 308 and based on the temperature being within at the optimal temperature, the MCU 302 may output a same logic level to both voltage shifters, e.g., both to logic 0 or both to logic 1 so that VCCA is applied to terminals 126, 128 or GND is applied to terminals 126, 128 which results in no polarity (e.g., no positive or negative polarity or potential difference) being applied to the Peltier element 114. The Peltier element 114 is turned off so no heating is performed or no cooling is performed other than by the heat sink 106 as shown by a two dimensional diagram 600. Further, the junction temperature of the integrated circuit 120 is not changed by the Peltier element 114.

The arrangement of the controller 136 is exemplary in nature. In some examples, an output of the processing circuity 302 may be arranged to output voltages directly to the terminals 126, 128 rather than providing a logic level to the voltage shifter and the voltage shifter applying the voltage to the terminals 126, 128.

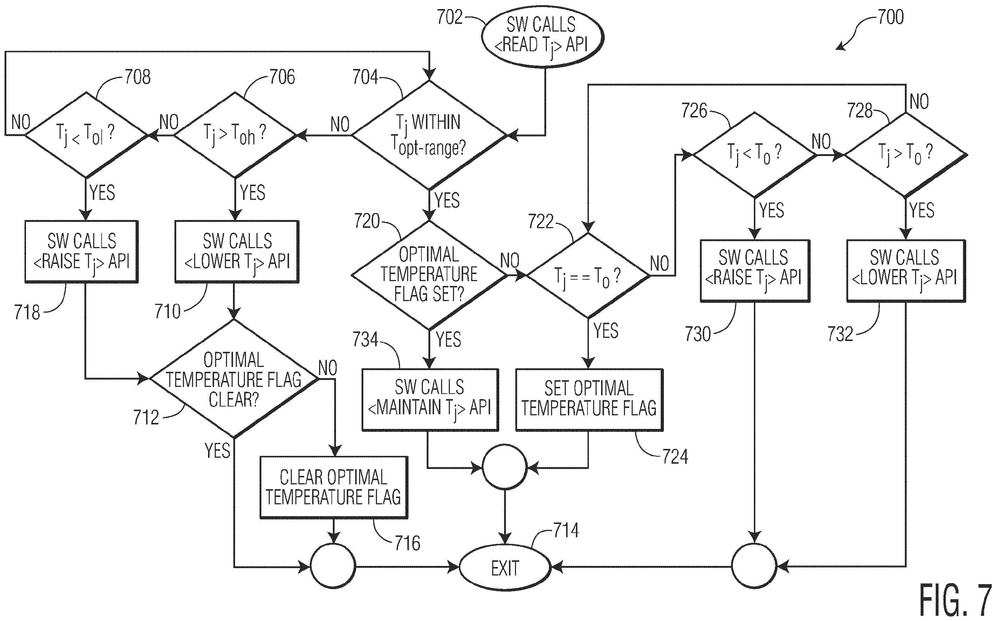

FIG. 7 illustrates an example flow chart 700 of functions associated with operation of the apparatus in accordance with an embodiment. In an example, the functions may be performed in software stored in memory via application programming interface (API) calls performed by the controller 136. The flow chart 700 defines functionality of the Peltier element 114 based on whether the junction temperature of the j unction 132 is within the optimal range or outside of the optimal range. If the junction temperature is within the optimal range, then the junction temperature is adjusted to reach an optimal temperature in the optimal range. Further, the controller logic may maintain the junction temperature in the optimal range when the junction temperature reaches the defined optimal temperature. If the junction temperature is not within the optimal range, then the junction temperature is adjusted to reach the optimal temperature in the optimal range. A flag such as a Boolean operator may be maintained to indicate based on a first value that junction temperature at an optimal temperature and a second value that the junction temperature is not at an optimal temperature. The flag may be set in accordance with operations in the flow chart 700.

At 702, the sensor provides an indication of the junction temperature. The sensor may be a temperature sensor or voltage sensor in an example. At 704, a determination is made whether the junction temperature is in the optimal range. If the junction temperature is not in the optimal range, then at 706, a determination is made whether the junction temperature is greater than an high end of the optimal range. If the junction temperature is not greater than the high end of the optimal range, then at 708, a determination is made whether the junction temperature is less than an low end of the optimal range. If the junction temperature is not less than the low end of the optimal range, then processing returns back to 704. If the junction temperature is greater than the high end at 706, then processing continues to 710 where controller causes a first polarity to be applied to the terminals of the Peltier element to cool the integrated circuit. At 712, a determination is made whether an optimal temperature flag is cleared (i.e., not set). If the flag is cleared, then processing continues to 714. If the flag is not cleared, then at 716, the flag is cleared and processing continues to 714 so that the flag indicates that the junction temperature may not be optimal temperature range. If the junction temperature is less than the low end of the optimal range at 708, then processing continues 718 where controller causes a second polarity to be applied to the terminals of the Peltier element to heat the integrated circuit and processing continues to 712. The first polarity may be different or opposite compared to the second polarity in the example.

If the junction temperature is in the optimal range at 704, then a determination is made at 720 whether the optimal temperature flag is set. If the optimal temperature flag is set, then at 734 the junction temperature is maintained and processing continues to 714. If the flag is not set, then at 722, a determination is made whether the junction temperature is equal to the optimal temperature. If the junction temperature is equal to the optimal temperature, then processing continues to 724 where the optimal temperature flag is set to indicate the optimal temperature is reached and processing continues to 714. If the junction temperature is not equal to the optimal temperature, then at 726 a determination is made whether the junction temperature is less than the optimal temperature. If the junction temperature is not less than the optimal temperature, then at 728, a determination is made whether the junction temperature is greater than the optimal temperature. If the junction temperature is greater than the optimal temperature, then processing continues to 732 where the controller causes a first polarity to be applied to the terminals of the Peltier element to cool the integrated circuit and processing continues to 714. If the junction temperature is less than the optimal temperature at 726, then processing continues to 730 where the controller causes a second polarity to be applied to the terminals of the Peltier element to heat the integrated circuit and processing continues to 714. In examples, the functions 700 cause the temperature of the integrated circuit to be in the optimal range to maintain reliability of the integrated circuit.

Apparatus and method for improving reliability of an integrated circuit. The apparatus comprises an integrated circuit and a heatsink which is in contact with package of the integrated circuit. A Peltier element comprises a first surface and a second surface and is positioned in a cavity of the heatsink. Based on a first indication from a sensor, a controller applies a first polarity to a first terminal and second terminal of the Peltier element to reduce a temperature of the second surface to cool the integrated circuit and based on a second indication from the sensor, the controller applies a second polarity to the first terminal and second terminal of the Peltier element to increase the temperature of the second surface to heat the integrated circuit.

In an embodiment, a system is disclosed. The system comprises: an integrated circuit; a heatsink which is in contact with packaging of the integrated circuit; a Peltier element comprising a first surface and a second surface and positioned in a cavity of the heatsink; and a controller; wherein based on a first indication from a sensor, the controller applies a first polarity to a first terminal and second terminal of the Peltier element to reduce a temperature of the second surface to cool the integrated circuit and based on a second indication from the sensor, the controller applies a second polarity to the first terminal and second terminal of the Peltier element to increase the temperature of the second surface to heat the integrated circuit. In an example, the Peltier element comprises the first terminal and the second terminal which are coupled to the first surface and the second surface of the Peltier element respectively. In an example, the controller is coupled to a first voltage shifter and a second voltage shifter, the first terminal is coupled to the first voltage shifter and the second terminal is coupled to the second voltage shifter. In an example, the first voltage shifter is arranged to output a greater voltage than the second voltage shifter to apply the first polarity and the first voltage shifter is arranged to output a voltage less than the second voltage shifter to apply the second polarity. In an example, the first indication indicates a junction temperature of the integrated circuit and the controller is arranged to apply the first polarity based on the junction temperature being greater than a high end of an optimal temperature range. In an example, the first polarity causes the first surface of the Peltier element to heat and the second surface of the Peltier element to cool. In an example, the system further comprises a fan arranged to draw heat from heatsink fins of the heatsink when the fan is enabled. In an example, the second indication indicates a junction temperature of the integrated circuit and the controller is arranged to apply the second polarity based on the junction temperature being less than a low end of an optimal temperature range. In an example, the second polarity causes the first surface of the Peltier element to cool and the second surface of the Peltier element to heat. In an example, the system further comprises a fan arranged to draw heat from heatsink fins, wherein the fan is disabled. In an example, a portion of circuitry of the controller is located in the integrated circuit.

In another embodiment, a method is disclosed. The method comprises receiving an indication of a junction temperature from a sensor; comparing the junction temperature to a high end of an optimal temperature range and a low end of the optimal temperature range; based on the junction temperature being higher than the high end, causing a first surface of a Peltier element to heat and a second surface of the Peltier element to cool; and based on the junction temperature being lower than the low end, causing the first surface of the Peltier element to cool and the second surface of the Peltier element to heat; wherein the Peltier element is located in a cavity of the heat sink and the heat sink is in contact with packaging of the integrated circuit. In an example, the method further comprises enabling the fan based on the junction temperature being higher than the high end and disabling the fan based on the junction temperature being lower than the low end, the fan being arranged to remove heat from the heat sink when enabled. In an example, causing the first surface of the Peltier element to heat and the second surface of the Peltier element to cool comprises applying a first polarity to terminals of the Peltier element and causing the first surface of the Peltier element to cool and the second surface of the Peltier element to heat comprises applying a second polarity to terminals of the Peltier element. In an example, the first polarity is based on applying a first voltage to a first terminal of the Peltier element and a second voltage to a second terminal of the Peltier element and the second polarity is based on applying the second voltage to the first terminal of the Peltier element and the voltage to the second terminal of the Peltier element. In an example, a surface of the Peltier element is heated or cooled based on the indication of the junction temperature until the junction temperature reaches an optimal temperature. In an example, the method further comprises based on the junction temperature being at the optimal temperature, stop applying a positive or negative polarity to terminals of the Peltier element. In an example, the method further comprises activating a fan coupled to the heat sink based on the junction temperature being higher than the high end. In an example, the method further comprises deactivating a fan coupled to the heat sink based on the junction temperature being lower than the low end. In an example, causing the first surface of the Peltier element to heat and the second surface of the Peltier element to cool comprises causing a first volage shifter to apply a first voltage to a first terminal of the Peltier element and causing a second volage shifter to apply a second voltage to a second terminal of the Peltier element.

A few implementations have been described in detail above, and various modifications are possible. The disclosed subject matter, including the functional operations described in this specification, can be implemented in electronic circuit, computer hardware, firmware, software, or in combinations of them, such as the structural means disclosed in this specification and structural equivalents thereof: including potentially a program operable to cause one or more data processing apparatus such as a processor to perform the operations described (such as a program encoded in a non-transitory computer-readable medium, which can be a memory device, a storage device, a machine-readable storage substrate, or other physical, machine readable medium, or a combination of one or more of them).

While this specification contains many specifics, these should not be construed as limitations on the scope of what may be claimed, but rather as descriptions of features that may be specific to particular implementations. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the implementations described above should not be understood as requiring such separation in all implementations.

Use of the phrase "at least one of' preceding a list with the conjunction "and" should not be treated as an exclusive list and should not be construed as a list of categories with one item from each category, unless specifically stated otherwise. A clause that recites "at least one of A, B, and C" can be infringed with only one of the listed items, multiple of the listed items, and one or more of the items in the list and another item not listed.

Other implementations fall within the scope of the following claims.

## Claims

1. A system comprising:
an integrated circuit;
a heatsink which is in contact with packaging of the integrated circuit;
a Peltier element comprising a first surface and a second surface and positioned in a cavity of the heatsink; and
a controller;
wherein based on a first indication from a sensor, the controller applies a first polarity to a first terminal and second terminal of the Peltier element to reduce a temperature of the second surface to cool the integrated circuit and based on a second indication from the sensor, the controller applies a second polarity to the first terminal and second terminal of the Peltier element to increase the temperature of the second surface to heat the integrated circuit.

2. The system of claim 1, wherein the Peltier element comprises the first terminal and the second terminal which are coupled to the first surface and the second surface of the Peltier element respectively.

3. The system of claim 1 or 2, wherein the controller is coupled to a first voltage shifter and a second voltage shifter, the first terminal is coupled to the first voltage shifter and the second terminal is coupled to the second voltage shifter.

4. The system of claim 3, wherein the first voltage shifter is arranged to output a greater voltage than the second voltage shifter to apply the first polarity and the first voltage shifter is arranged to output a voltage less than the second voltage shifter to apply the second polarity.

5. The system of any preceding claim, wherein the first indication indicates a junction temperature of the integrated circuit and the controller is arranged to apply the first polarity based on the junction temperature being greater than a high end of an optimal temperature range.

6. The system of claim 5, wherein the first polarity causes the first surface of the Peltier element to heat and the second surface of the Peltier element to cool.

7. The system of claim 6, further comprising a fan arranged to draw heat from heatsink fins of the heatsink when the fan is enabled.

8. The system of any preceding claim, wherein the second indication indicates a junction temperature of the integrated circuit and the controller is arranged to apply the second polarity based on the junction temperature being less than a low end of an optimal temperature range.

9. The system of claim 8, wherein the second polarity causes the first surface of the Peltier element to cool and the second surface of the Peltier element to heat.

10. The system of claim 9, comprising a fan arranged to draw heat from heatsink fins, wherein the fan is disabled.

11. The system of any preceding claim, wherein at least a portion of circuitry of the controller is located in the integrated circuit.

12. A method comprising:
receiving from a sensor an indication of a junction temperature of an integrated circuit;
comparing the junction temperature to a high end of an optimal temperature range and a low end of the optimal temperature range;
based on the junction temperature being higher than the high end, causing a first surface of a Peltier element to heat and a second surface of the Peltier element to cool; and
based on the junction temperature being lower than the low end, causing the first surface of the Peltier element to cool and the second surface of the Peltier element to heat;
wherein the Peltier element is located in a cavity of the heat sink and the heat sink is in contact with packaging of the integrated circuit.

13. The method of claim 12, further comprising enabling the fan based on the junction temperature being higher than the high end and disabling the fan based on the junction temperature being lower than the low end, the fan being arranged to remove heat from the heat sink when enabled.

14. The method of claim 12 or 13, wherein causing the first surface of the Peltier element to heat and the second surface of the Peltier element to cool comprises applying a first polarity to terminals of the Peltier element and causing the first surface of the Peltier element to cool and the second surface of the Peltier element to heat comprises applying a second polarity to the terminals of the Peltier element.

15. The method of claim 14, wherein the first polarity is based on applying a first voltage to a first terminal of the Peltier element and a second voltage to a second terminal of the Peltier element and the second polarity is based on applying the second voltage to the first terminal of the Peltier element and the voltage to the second terminal of the Peltier element.
